# EUROPEAN PATENT APPLICATION

(11) **EP 2 402 480 A1**
(43) Date of publication of application: **04.01.2012**
(21) Application number: 10746189.9
(22) Date of filing: 23.02.2010
(51) Int. Cl.: C23C 14/24, C23C 16/448, H01L 51/50, H05B 33/10

(54) **ORGANIC COMPOUND STEAM GENERATOR AND APPARATUS FOR PRODUCING ORGANIC THIN FILM**

(30) Priority: 24.02.2009 JP 2009041071
(71) Applicant: ULVAC, INC., Chigasaki-shi Kanagawa 253-8543 (JP)
(72) Inventor: NEGISHI, Toshio, Chigasaki-shi Kanagawa 253-8543 (JP); HIRAIWA, Hideyuki, Chigasaki-shi Kanagawa 253-8543 (JP)
(74) Representative: Körber, Martin Hans
(86) International application number: PCT/JP2010/052734
(87) International publication number: WO 2010/098308

(57) **Abstract**

Provided is a technology with which a vapor of an organic compound generated in a generating chamber does not flow back into an inner connection pipe for feeding the organic compound into the generating chamber. An apparatus 1 for producing an organic thin film includes a storage chamber 31 in which an organic material is placed, a generating chamber 33 for generating a vapor of the organic material by heating the organic material, and a transporting device 32 for feeding the organic material inside the storage chamber 31 into the generating chamber 33. The transporting device 32 includes an outer connection pipe 37 for gas-tightly connecting an inner atmosphere of the storage chamber 31 and an inner atmosphere of the generating chamber 33, an inner connection pipe 38 arranged inside the outer connection pipe 37, made of quartz and constructed so as to move the organic material from the interior of the storage chamber 31 to an interior of the generating chamber 33, and a gas introduction opening 42 for introducing a gas into the inner connection pipe 38.

## Description

### TECHNICAL FIELD

The present invention relates to an evaporation source to be used for producing organic EL and an apparatus for producing organic EL.

### BACKGROUND ART

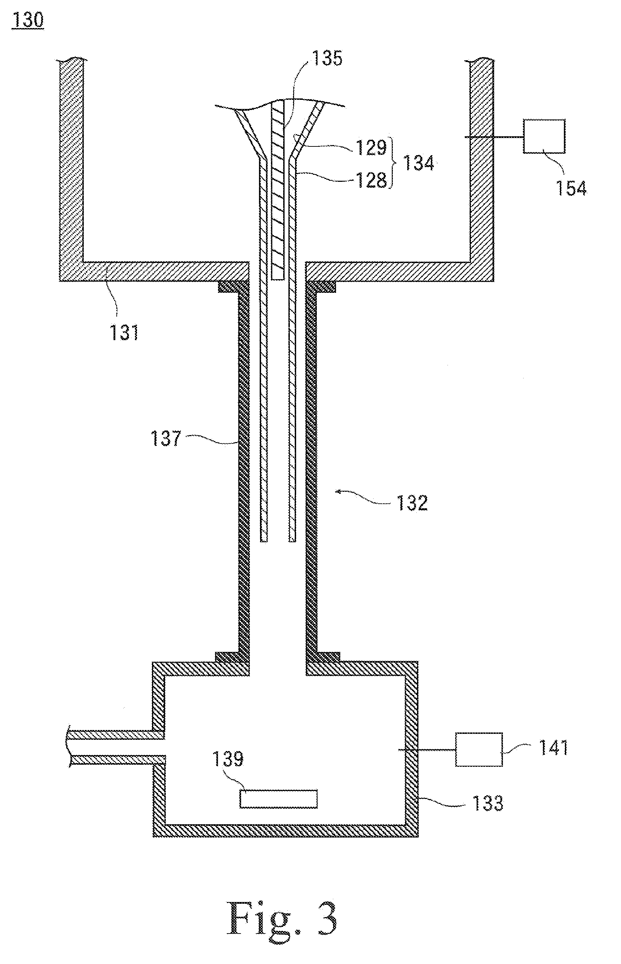

A conventional apparatus for generating a vapor 130 shown in Fig. 3 has a storage chamber 131, a transporting device 132, and a generating chamber 133.

A funnel-shaped funnel vessel 134 is vertically arranged inside the storage chamber 131. The funnel vessel 134 has a funnel slope 129 having an inverted conical shape and a tubular insertion portion 128 which is a pipe connected to a hole at a central position of the funnel shape. The tubular insertion portion 128 extends vertically downwardly, and a measuring rod 135 is inserted vertically through the interior of the tubular insertion portion 128 from a position above the upper end of the tubular insertion portion 128.

The generating chamber 133 is arranged under the storage chamber 131, and the transporting device 132 is arranged between the storage chamber 131 and the generating chamber 133.

The transporting device 132 has an outer connection pipe 137; and the upper end of the outer connection pipe 137 is attached to a bottom face of the storage chamber 131, whereas the lower end thereof is attached to a ceiling of the generating chamber 133. The interior of the storage chamber 131 is connected to that of the generating chamber 133 through the outer connection pipe 137. The tubular insertion portion 128 is inserted into the outer connection pipe 137.

When an organic material is fed into the funnel vessel 134 and the organic material is dropped downwardly from the lower end of a thread groove formed in the measuring rod 135, it drops onto a bottom face of the generating chamber 133 through the interior of the tubular insertion portion 128 of the funnel vessel 134, and the organic material is heated by a heat generator 139 arranged on the bottom face of the generating chamber 133, thereby generating a vapor of the organic material.

This vapor of the organic material is fed out of the generating chamber 133 by a carrier gas which is fed into the generating chamber 133 from the gas introduction system 141 connected to the generating chamber 133.

In the conventional apparatus for generating a vapor 130, the problem occurs that the vapor of the organic material generated inside the generating chamber 133 flows back into the tubular insertion portion 128.

### PRIOR ART DOCUMENTS

### PATENT DOCUMENTS

Patent Document 1: JP-A 2006-307239
Patent Document 2: JP-A 2003-226961

### SUMMARY OF THE INVENTION

### PROBLEM TO BE SOLVED BY THE INVENTION

The present invention has been made to solve the inconvenience of the above-described conventional art, and the aim of the present invention is to provide an apparatus in which a vapor of an organic compound generated inside a generating chamber does not flow back into a connection pipe for feeding the vapor of the organic compound into the generating chamber.

### MEASURES TO SOLVE THE PROBLEMS

In order to solve the above-described problem, the present invention is directed to an apparatus for generating a vapor of an organic compound comprising a storage chamber in which an organic material is placed, a generating chamber in which a vapor of the organic material is generated by heating the organic material, and a transporting device for feeding the organic material inside the storage chamber into the generating chamber, wherein the transporting device comprises a connection pipe for gas-tightly connecting an inner atmosphere of the storage chamber and an inner atmosphere of the generating chamber, passing the organic material inside the storage chamber and moving it into the generating chamber, and a gas introduction opening formed in the connection pipe and constructed so as to introduce a gas into the connection pipe when connected to a gas introduction system for feeding the gas.

The present invention is also directed to the apparatus for generating the vapor of the organic compound in which, inside the storage chamber, a funnel-shaped vessel in a funnel shape is inserted into the connection pipe in a state where a slope of the funnel shape is directed upwardly and a tubular insertion portion in a tubular shape connected to a hole located in a center of the funnel shape is directed downwardly, a lower end of the tubular insertion portion is located inside the connection pipe, a powder of the organic material is placed on the slope, the organic material inside the funnel-shaped vessel is fed into the generating chamber from the lower end of the tubular insertion portion through an interior of the connection pipe, the introduction opening is formed such that the gas is fed between the tubular insertion portion and the connection pipe inside the connection pipe, and the gas to be fed is introduced into the generating chamber through a gap between the tubular insertion portion and the connection pipe.

The present invention is directed to the apparatus for generating the vapor of the organic compound, wherein a measuring rod having a thread groove formed spirally in a lateral face with a lower end opened is inserted into the funnel-shaped vessel such that a lower end of the thread groove is positioned inside the tubular insertion portion, and by rotating the measuring rod, the organic material moves inside the thread groove, drops, and is fed into the transporting device from the tubular insertion portion.

Further, the present invention is directed to the apparatus for generating the vapor of the organic compound, wherein the connection pipe comprises an outer connection pipe and an inner connection pipe, the inner connection pipe is arranged inside the outer connection pipe, a lower end of the inner connection pipe is positioned inside the generating chamber, the tubular insertion portion is inserted into the inner connection pipe, and a lower end of the tubular insertion portion is positioned inside the inner connection pipe.

Further, the present invention is directed to the apparatus for generating the vapor of the organic compound, wherein heat conductivity of the inner connection pipe is set lower than heat conductivity of the outer connection pipe.

The present invention is directed to the apparatus for generating the vapor of the organic compound, wherein the outer connection pipe is provided with a cooling path through which a cooling medium flows.

The present invention is directed to the apparatus for generating the vapor of the organic compound, wherein the inner connection pipe is formed such that an apical portion positioned inside the generating chamber is tapered toward a tip.

The present invention is directed to the apparatus for generating the vapor of the organic compound, wherein a lower end of the tubular insertion portion is positioned inside the inner connection pipe, a gap is formed between the tubular insertion portion and the inner connection pipe, the gas is introduced into the gap through the gas introduction opening, and the introduced gas flows toward the lower end of the tubular insertion portion through the gas introduction opening.

The present invention is directed to the apparatus for generating a vapor of a compound, wherein each of the funnel-shaped vessel is constructed so as to be capable of being inserted into or pulled out from an interior of the inner connection pipe by moving up and down relative to the inner connection pipe, and an on/off valve is provided between the storage chamber and the transporting device, the on/off valve being capable of turning off a connection between an interior of the storage chamber and an interior of the transporting device when the tubular insertion portion is pulled out from the inner connection pipe.

The present invention is directed to the apparatus for generating the vapor of the organic compound, wherein a liquid-feeding vessel, in which a liquid of the organic compound is placed, and an ejection device for feeding the organic compound inside the liquid-feeding vessel into the transporting device are provided inside the storage chamber.

The present invention is directed to an apparatus for producing an organic thin film comprising a film forming chamber, a discharge device arranged inside the film forming chamber, and the apparatus for generating the vapor of the organic compound as described above, wherein an interior of the discharge device and an interior of the apparatus for generating the vapor of the organic compound are connected with each other via a connection valve for switching conduction and turning off of the vapor of the organic compound, an organic material, which moves from the storage chamber to the generating chamber through the transporting device, generates a gas of the organic material by being heated in the generating chamber, and the generated gas of the organic material is discharged into the film forming chamber through the discharge device.

Furthermore, the present invention is directed to the apparatus for producing the organic thin film, wherein the connection valve connects an interior of the generating chamber to a fixing device for fixing the vapor of the organic compound when the connection pipe turns off the connection between the interior of the discharge device and the interior of the generating chamber.

### EFFECTS OF THE INVENTION

According to the present invention, it is difficult for the vapor of the organic compound to enter the interior of the connection pipe for feeding the organic compound into the generating chamber. In particular, the invention can provide the apparatus for producing the organic thin film, in which the inner connection pipe makes it difficult for the vapor of the organic compound generated in the generating chamber to enter the interior of the inner connection pipe, and even when a lower portion of the inner connection pipe is heated inside the generating chamber, heat is difficult to be conducted to an upper end portion of the inner connection pipe.

### BRIEF DESCRIPTION OF THE DRAWINGS

Fig. 1 is a sectional view of an apparatus for producing an organic thin film according to the present invention.
Fig. 2 is a sectional view of an apparatus for generating a vapor according to the present invention.
Fig. 3 is a sectional view of an apparatus for generating a vapor in the prior art.

### EXPLANATION OF REFERENCE NUMERALS

1 --- apparatus for producing an organic thin film, 5 --- substrate, 10 --- film forming chamber, 20 --- connection valve, 27 --- extension portion, 28 --- tubular insertion portion, 29 --- funnel slope, 30 --- apparatus for generating a vapor, 31 --- storage chamber, 32 --- transporting device, 33 --- generating chamber, 34 --- funnel vessel, 35measuring rod, 36 --- gap, 37 --- outer connection pipe, 38 --- inner connection pipe, 39 --- heat generator, 41 --- gas introduction system, 42 --- gas introduction opening, 49ejection opening, 50 --- vapor discharge device, 51discharging opening, 52 --- cooling path, 53 --- temperature control/circulation unit, 54, 55 --- vacuum evacuation system, 60 --- cooling trap, 61 --- cooling device, 62 --- cooling plate

### EMBODIMENTS TO CARRY OUT THE INVENTION

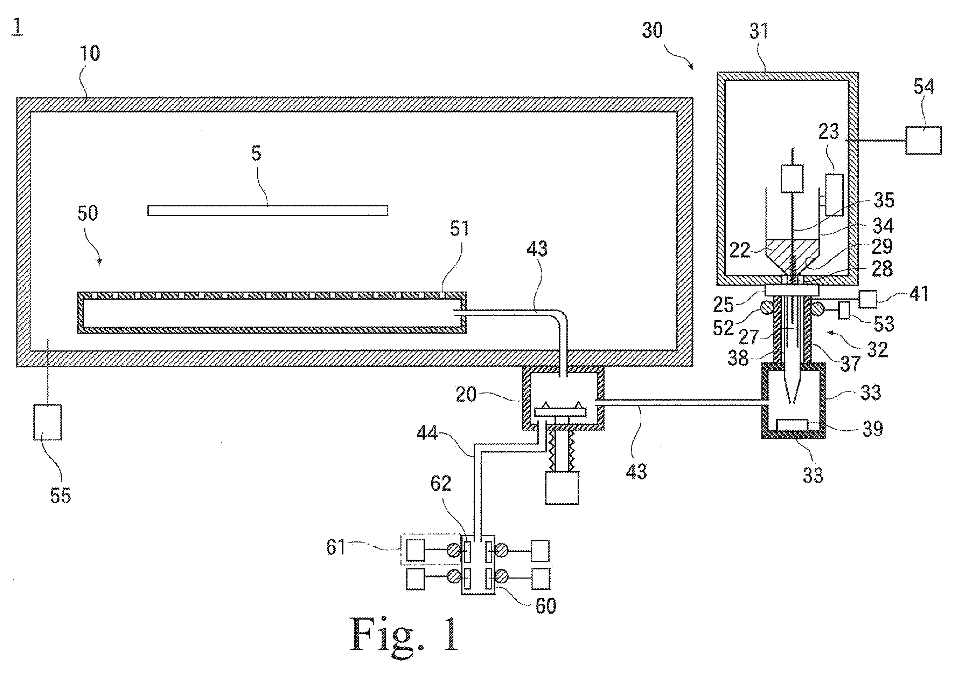

In Fig. 1, a reference numeral 1 denotes an apparatus for producing an organic thin film (vapor deposition apparatus) as one embodiment of the present invention.

This apparatus 1 for producing the organic thin film has a film forming chamber 10, an apparatus 30 for generating a vapor, and a vapor discharge device 50.

The vapor discharge device 50 is arranged inside the film forming chamber 10. The apparatus 30 for generating a vapor is connected to the vapor discharge device 50 via a connection valve 20; and the connection valve 20 is constructed such that when it is in a conduction state, a vapor of an organic compound generated inside the apparatus 30 for generating a vapor is fed into the vapor discharge device 50. The vapor of the organic compound fed into the vapor discharge device 50 is discharged into the film forming chamber 10 exposed to a vacuum atmosphere through plural discharge openings 51 of the vapor discharge device 50.

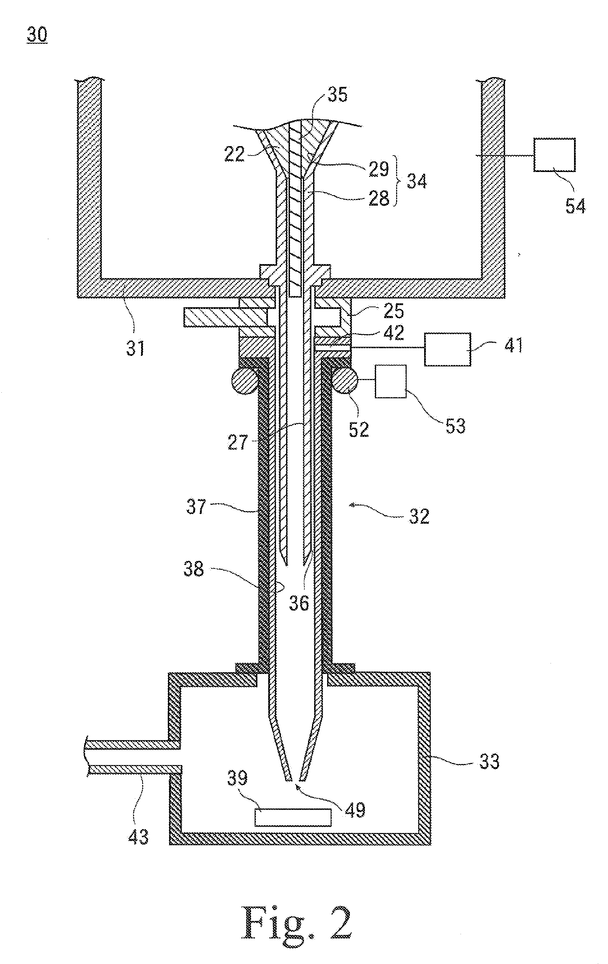

An apparatus 30 for generating a vapor shown in Fig. 2 is one embodiment of the present invention, and it has a storage chamber 31, a transporting device 32 and a generating chamber 33.

A funnel-shaped funnel vessel 34 is arranged vertically inside the storage chamber 31. The funnel vessel 34 comprises a funnel slope 29, which has a large-diameter funnel-opening portion at the upper portion and an inverted conical shape which is inclined downwardly while the diameter becomes smaller as it approaches the center, and a hole at the center of the funnel shape which is the lower end of the funnel slope 29. The funnel vessel 34 also comprises a tubular insertion portion 28 which is a pipe connected to the hole at the upper end thereof. A reference numeral 22 in Figs. 1 and 2 denotes a powder of an organic compound placed on the funnel slope 29 inside this funnel vessel 34.

The tubular insertion portion 28 of the funnel vessel 34 extends vertically downwardly; and a measuring rod 35 is inserted vertically into the tubular insertion portion 28 from a position above the upper end of the tubular insertion portion 28.

A helical thread groove is formed on a lateral side of the measuring rod 35 from above the upper end of the tubular insertion portion 28 to the inside of the tubular insertion portion 28.

An apex of the thread ridge between the thread grooves on the lateral side of the measuring rod 35 is in contact with an inner wall face of the tubular insertion portion 28 or is spaced with a slight gap from the inner wall face of the tubular insertion portion 28, so that the measuring rod 35 can rotate around its central axis.

If there is a gap between the apex of the thread ridge between the thread grooves and the inner wall face of the tubular insertion portion 28, the gap is set to be smaller than diameters of particles (powder) of the organic compound used. In a state in which the measuring rod 35 is inserted into the tubular insertion portion 28 of the funnel vessel 34 and the measuring rod 35 remains still, the powdery organic compound 22 fed into the funnel vessel 34 is accumulated on the funnel slope 29 without dropping into the tubular insertion portion 28.

The transporting device 32 is arranged under the storage chamber 31. An on/off valve 25 is arranged between a bottom face of the storage chamber 31 and the upper end of the transporting device 32; and the interior of the storage chamber 31 is connected to that of the transporting device 32 via the on/off valve 25.

The generating chamber 33 is arranged under the transporting device 32; and the lower end of the transporting device 32 is attached to a ceiling of the generating chamber 33.

The transporting device 32 has a connection pipe.

This connection pipe is constructed by an outer connection pipe 37 and an inner connection pipe 38 arranged inside the outer connection pipe 37. The upper end of the outer connection pipe 37 is attached to the bottom face of the storage chamber 31 via the on/off valve 25.

Holes are formed in the bottom face of the storage chamber 31 and the ceiling of the generating chamber 33 at positions to which the outer connection pipe 37 is attached, respectively, and the holes are located inside the outer connection pipe 37. When the on/off valve 25 is opened, the interior of the storage chamber 31 is connected to that of the generating chamber 33 via the holes and the outer connection pipe 37.

The connection between the storage chamber 31 and the outer connection pipe 37 via the on/off valve 25 and the connection between the generating chamber 33 and the outer connection pipe 37 are made gas-tight; and when the interior of the storage chamber 31 and of the generating chamber 33 is evacuated to vacuum in the state where the on/off valve 25 is opened, the interior of the storage chamber 31, of the outer connection pipe 37, and of the generating chamber 33 can be set in a vacuum atmosphere.

After the on/off valve 25 is set in the open state, the tubular insertion portion 28 penetrates the on/off valve 25; and the upper end of the tubular insertion portion 28 is positioned inside the storage chamber 31, whereas the lower end thereof is positioned inside the inner connection pipe 38.

When the tubular insertion portion 28 is moved into the upper storage chamber 31 and pulled out from the on/off valve 25, the on/of valve 25 can be set in a closed state.

When the on/off valve 25 is in the closed state, the atmosphere can be introduced into the storage chamber 31, while the vacuum atmosphere inside the generating chamber 33 and inside the transporting device 32 is maintained.

The inner connection pipe 38 is set vertically inside the outer connection pipe 37; and its upper end is directed toward a side of the storage chamber 31, whereas the lower end thereof is inserted into the generating chamber 33 through the hole of the ceiling of the generating chamber 33.

In this embodiment, in ordinarily operating the apparatus, the on/off valve 25 is in the open state, and a lower portion of the tubular insertion portion 28 extends into the interior of the inner connection pipe 38 positioned inside the outer connection pipe 37 through the on/off valve 25, so that the lower end of the tubular insertion portion 28 is positioned inside the inner connection pipe 38. Meanwhile, the lower end of the tubular insertion portion 28 may be positioned inside the storage chamber 31. In that case, the upper end of the inner connection pipe 38 may extend into the interior of the storage chamber 31.

The size of the thread groove of the measuring rod 35 is made larger than the particle diameters of the organic compound (the diameters of the powder), so that the organic compound can move into the thread groove. The organic compound enters the thread groove at a position above the upper end of the tubular insertion portion 28 at which the funnel slope 29 and the tubular insertion portion 28 are connected with each other; and when the measuring rod 35 is rotated, the organic compound moves downwardly in the thread groove.

The thread groove ends at the lower end or at a midway position of the measuring rod 35; and the measuring rod 35 ends at a midway position of the tubular insertion portion 28. In Fig. 2, a reference numeral 27 denotes that extension portion of the tubular insertion portion 28 which is located under the measuring rod 35.

The thread groove is not closed at the position of the lower end of the thread groove; a space inside the thread groove is connected to a space inside the tubular insertion portion 28; and the space inside the tubular insertion portion 28 is connected to a space inside the inner connection pipe 38 via a hole at the lower end of the extension portion 27 of the tubular insertion portion 28.

An ejection opening 49 is formed at the lower end of the inner connection pipe 38; and the ejection opening 49 is located, inside the generating chamber 33, at a height such that there is a gap between the ejection opening 49 and the bottom face of the generating chamber 33. The edge of the ejection opening 49 is circular, and its diameter is 0.5mm to 3mm. A heat generator 39 is arranged at a position of that bottom face of the generating chamber 33 which faces the ejection opening 49; and the height of the gap between the ejection opening 49 and the heat generator 39 is 1mm to 2mm. In this embodiment, the diameter of the ejection opening 49 is set at 0.5mm, and the height of the gap is set at 1mm.

Therefore, the organic compound moving to the position of the lower end of the thread groove inside the thread groove drops downwardly from the lower end of the thread groove through the space inside the extension portion 27. Then, the organic compound enters the inner connection pipe 38 through the extension portion 27, and drops onto the heat generator 39 arranged on the bottom face of the generating chamber 33 from the ejection opening 49 through the inner connection pipe 38. A drop amount of the organic compound is proportional to a rotation amount of the measuring rod 35, so that a desired amount of the organic compound can be dropped.

The heat generator 39 is heated to a temperature of 300°C or more to 400°C or less by a preliminary passage of an electric current. Meanwhile, the generating chamber 33 is placed inside a reflector casing, so that heat generated from the heat generator 39 is not radiated to the outside of the reflector casing.

The particles of the organic compound dropped on the bottom face of the generating chamber 33 are heated by heat conduction from the heat generator 39 and/or the radiation heat irradiated from the lateral wall, and are evaporated when being heated to the evaporation temperature of the organic compound or more, so that a vapor of the organic compound is generated inside the generating chamber 33.

A gas introduction system 41 is arranged outside the apparatus 30 for generating a vapor.

The inner connection pipe 38 has a portion contacting the outside atmosphere of the transporting device 32 at a position above the lower end of the tubular insertion portion 28; and a gas introduction opening 42 is formed in that portion.

A gap 36 is formed between the inner connection pipe 38 and the extension portion 27 of the tubular insertion portion 28 inserted into the inner connection pipe 38. The gap 36 between the inner connection pipe 38 and the extension portion 27 is closed at the upper end.

The gas introduction opening 42 is connected to the gap 36, and arranged at a position higher than the lower end of the extension portion 27.

The gas introduction opening 42 is connected to the gas introduction system 4; and a gas fed from the gas introduction system 41 can be introduced into the gap 36 inside the inner connection pipe 38.

The interior of the generating chamber 33 can be connected to the vapor discharge device 50 via a pipe 43 having a connection valve 20.

The connection valve 20 is constructed so as to connect the interior of the generating chamber 33 and that of the vapor discharge device 50 or to turn off the connection between the interior of the generating chamber 33 and that of the vapor discharge device 50. The interior of the film forming chamber 10 is connected to a vacuum evacuating system 55; and when the interior of the film forming chamber 10 is evacuated to vacuum by the vacuum evacuation system 55 in a state where the interior of the vapor discharge device 50 is connected to that of the generating chamber 33 via the connection valve, the interior of the generating chamber 33 and of the storage chamber 31 is evacuated to vacuum via the vapor discharge device 50 and the connection valve 20.

In this state, when a carrier gas composed of a rare gas such as Ar is introduced into the inner connection pipe 38 through the gas introduction opening 42 of the inner connection pipe 38 by the gas introduction system 41, the introduced carrier gas is ejected into the inner connection pipe 38 at the lower end of the extension portion 27 through the gap 36 between the inner connection pipe 38 and the extension portion 27, and flows from the position of the lower end of the extension portion 27 inside the inner connection pipe 38 toward the ejection opening 49 at the lower end of the inner connection pipe 38.

When the particles of the organic compound dropped from the position of the lower end of the thread groove drop inside the inner connection pipe 38 from the lower end of the extension portion 27, they flow toward the ejection opening 49 while riding on the flow of the carrier gas, so that the particles do not adhere to an inner wall face of the inner connection pipe 38.

The carrier gas and the particles of the organic compound carried with the carrier gas are ejected toward the heat generator 39 from the ejection opening 49; and the particles of the organic compound scatter onto the heat generator 39. Therefore, each of the particles of the organic compound is uniformly heated without gathering at one location on the heat generator 39, and the particles of the organic compound disappear by being evaporated in a short time.

The vapor of the organic compound generated inside the generating chamber 33 moves into the vapor discharge device 50 via the connection valve 20 by the flow of the carrier gas, and is discharged into the film forming chamber 10 in the vacuum atmosphere through the discharge openings 51 of the vapor discharge device 50.

An object to be film-formed (substrate 5) is placed at a position facing the discharge openings 51 of the vapor discharge device 50, and the vapor of the organic compound discharged from the discharge openings 51 reaches a surface of the object to be film-formed (substrate 5), thereby forming a thin film of the organic compound.

If the vapor of the organic compound generated in the generating chamber 33 enters the inner connection pipe 38, the vapor of the organic compound reaches the lower end of the thread groove through the interior of the inner connection pipe 38, and the vapor of the organic compound melts the organic compound near the lower end of the thread groove, thereby fusing the particles. This causes the lower end of the thread groove to be blocked.

In the present invention, the lower portion of the inner connection pipe 38 for feeding the organic compound 22 into the generating chamber 33 is tapered; the ejection opening 49 positioned at the lower end of the inner connection pipe 38 is made smaller in diameter than the upper portion of the inner connection pipe 38; and further the carrier gas is introduced into the inner connection pipe 38 and blown out through the ejection opening 49. Therefore, it is difficult for the vapor of the organic compound generated in the generating chamber 33 to enter the inner connection pipe 38.

In addition, the carrier gas fed into the inner connection pipe 38 is fed at such a flow rate as to pressurize the interior of the inner connection pipe 38 to a pressure allowing viscous flow (in a range of 10Pa or more to 150Pa or less) (in one example, when the diameter of the ejection opening 49 at the lower end of the inner connection pipe 38 is 0.5mm and feeding is carried out at 0.5 to 2SCCM, the pressure is within the above-described pressure range of the viscous flow) ; and the carrier gas flows from a position above the lower end of the tubular insertion portion 28 toward the ejection opening 49 inside the inner connection pipe 38.

If the vapor of the organic compound enters the interior of the inner connection pipe 38 from the lower end of the ejection opening 49, the vapor of the organic compound is pushed back by the viscous flow of the carrier gas inside the inner connection pipe 38, and returned into the generating chamber 33 through the ejection opening 49.

The pressure inside the generating chamber 33 is set to 1x10⁻⁵Pa or more to 1x10⁻²Pa or less by evacuating the film forming chamber 10 to vacuum, so that the inner pressure of the inner connection pipe 38 is larger than the pressure of the atmosphere inside the generating chamber 33 outside the inner connection pipe 38.

The thinly tapered portion of the inner connection pipe 38 is positioned inside the generating chamber 33, and heated with the radiation heat from the wall face of the generating chamber 33.

If particles of the organic compound dropping inside the inner connection pipe 38 come in contact with the wall face of the inner connection pipe 38 near the lower end of the thinly tapered portion of the inner connection pipe 38, are attached to the wall face and are melted, the ejection opening 49 gets blocked. In the present invention, since the carrier gas in the form of the viscous flow flows out through the ejection opening 49, the melted organic compound 22 is pushed back into the generating chamber 33 through the ejection opening 49, so that the ejection opening 49 is not blocked.

Next, the outer peripheral face of the inner connection pipe 38 and the inner peripheral face of the outer connection pipe 37 closely contact with each other; and the outer connection pipe 37 is provided with a cooling path 52 through which a liquid flows. In this embodiment, the cooling path 52 is a metallic pipe; and it is wound around the outer peripheral face of the metallic outer connection pipe 37 by one turn or plural turns and fixed by being welded thereto.

The cooling path 52 is connected to a temperature control/circulation unit 53; a liquid cooling medium cooled at around room temperature is fed into the cooling path 52 from the temperature control/ circulation unit 53; and the cooling medium heated by lowering the temperature of the outer connection pipe 37 returns to the temperature control/ circulation unit 53. In this manner, the temperature-controlled cooling media is circulated to the outer connection pipe 37 so that the outer connection pipe 37 may not be heated to a high temperature.

Therefore, even if the wall face of the generating chamber 33 is heated, the heat of the generating chamber 33 is not conducted to the storage chamber 31.

When the outer connection pipe 37 is cooled, the inner connection pipe 38 in contact with the outer connection pipe 37 is indirectly cooled, and thus, even if the particles of the organic compounds come in contact with the inner wall face of the inner connection pipe 38, the particles of the organic compound are not melted.

In addition, the outer connection pipe 37 is made of a metal, whereas the inner connection pipe 38 is made of ceramics (quartz in this embodiment) having a heat conductivity lower than that of the metal.

Therefore, even if the lower portion of the inner connection pipe 38 is heated inside the generating chamber 33, heat is difficult to be conducted to the upper end portion of the inner connection pipe 38.

When a thin film is formed on a surface of the substrate 5 by such an apparatus 1 for producing an organic thin film, the vacuum evacuation system 54 connected to the storage chamber 31 and the vacuum evacuation system 55 connected to the film forming chamber 10 are operated, and the interiors of the storage chamber 31, the transporting device 32, the generating chamber 33 and the film forming chamber 10 are preliminarily evacuated to a predetermined pressure. Furthermore, the temperature is raised by passing an electric current through the heat generator 39 inside the generating chamber 33.

Moreover, the apparatus 1 for producing the organic thin film has a cooling tarp 60; and when the connection valve 20 turns off the connection between the interior of the apparatus 30 for generating a vapor and that of the vapor discharge device 50, the interior of the apparatus 30 for generating a vapor is connected to that of the cooling trap 60 by a pipe 44.

In a state where the interior of the generating chamber 33 is connected to that of the vapor discharge device 50 by the connection valve 20, while the carrier gas is fed into the inner connection pipe 38 via the gas introduction system 41, a predetermined amount of the organic compound is dropped onto the heat generator 39 from the storage chamber 31, and the vapor of the organic compound is generated inside the generating chamber 33.

The generated vapor of the organic compound is introduced into the vapor discharge device 50 through the connection valve 20, and is discharged into the film forming chamber 10 from the discharge openings 51 of the vapor discharge device 50. The discharged vapor of the organic compound reaches a surface of the substrate 5 placed opposite the discharge openings 51 of the vapor discharge device 50, thereby forming an organic thin film.

After the above-described organic thin film is formed on the surface of the substrate 5, organic thin films having the same composition can be formed on plural substrates layer by layer by removing, from the film forming chamber 10, the substrate 5 on which the organic thin film is formed, bringing a substrate having no film formed thereinto, and repeatedly forming the organic thin films according to the above-described procedure.

In this apparatus 1 for producing an organic thin film, a plurality of the funnel vessels 34 are arranged inside the storage chamber 31, and the measuring rod 35 is inserted into each of the funnel vessels 34.

When a multilayered organic thin film is formed on plural substrates, after an organic thin film having a predetermined thickness is first formed on a substrate with an organic compound 22 inside the first funnel vessel 34, the connection valve 20 turns off the connection between the generating chamber 33 and the vapor discharge device 50, and connects the generating chamber 33 to the cooling trap 60.

Inside the cooling trap 60, cooling plates 62, which are cooled to 35°C or less by cooling devices 61 for circulating the cooling medium, are arranged. The vapor of the organic compound entering the cooling trap 60 is adhered onto the cooling plates 62 and exhausted, so that the vapor of the organic compound is removed from the interior of the generating chamber 33 and of the pipes.

The storage chamber 31 is provided with a motor 23; and the plural funnel vessels 34 can be moved vertically together with the measuring rods 35, while the vacuum atmosphere inside the storage chamber 31 and inside the transporting device 32 is maintained.

When the powder of the organic compound inside the funnel vessel 34 is consumed, the funnel vessel 34 is moved upwardly, the extension portion 27 of the tubular insertion portion 28 is pulled out from the inner connection pipe 38, and the on/off valve 25 is closed, so that the interior of the storage chamber 31 is disconnected from the interior of the transporting device 32 and that of the generating chamber 33. While the vacuum atmospheres inside the transporting device 32 and the generating chamber 33 are maintained, the storage chamber 31 is opened to the atmosphere, so that the powdery organic compound can be placed inside the funnel vessel 34.

The inner connection pipe 38 in the present invention is not limited to quartz, but may be ceramics.

Further, according to the apparatus 1 for producing the organic thin film of the present invention, by connecting plural apparatus 30 for generating a vapor to a single film forming chamber 10 via connection valves 20, respectively, forming a film in a state where the interior of any one of the apparatus 30 for generating a vapor is connected to the film forming chamber 10, and changing the connection valve 20 to be in a connection state, a thin film can be laminated on a surface of one substrate with a vapor of the organic compound purified in each of the apparatus 30 for generating a vapor.

When the films are formed on the plural substrates in this way, a desired organic thin film can be laminated on each of the substrates.

Meanwhile, the above-described organic material is in the form of particles, but if a desired amount of a liquid organic material can be fed into the generating chamber 33 at a desired time, it may be that the liquid organic material is placed in the storage chamber 31, and the liquid organic material is fed from the storage chamber 31 to the generating chamber 33, while the gas is introduced into the inner connection pipe 38.

## Claims

1. An apparatus for generating a vapor of an organic compound, which comprises a storage chamber in which an organic material is placed, a generating chamber in which a vapor of the organic material is generated by heating the organic material, and a transporting device for feeding the organic material inside the storage chamber into the generating chamber, **characterized in that** the transporting device comprises a connection pipe for gas-tightly connecting an inner atmosphere of the storage chamber and an inner atmosphere of the generating chamber, passing the organic material inside the storage chamber and moving it into the generating chamber, and a gas introduction opening formed in the connection pipe and constructed so as to introduce a gas into the connection pipe when connected to a gas introduction system for feeding the gas.

2. The apparatus for generating the vapor of the organic compound according to claim 1, wherein, inside the storage chamber, a funnel-shaped vessel in a funnel shape is inserted into the connection pipe in a state where a slope of the funnel shape is directed upwardly and a tubular insertion portion in a tubular shape connected to a hole located in a center of the funnel shape is directed downwardly, a lower end of the tubular insertion portion is located inside the connection pipe, a powder of the organic material is placed on the slope, the organic material inside the funnel-shaped vessel is fed into the generating chamber from the lower end of the tubular insertion portion through an interior of the connection pipe, the introduction opening is formed such that the gas is fed between the tubular insertion portion and the connection pipe inside the connection pipe, and the gas to be fed is introduced into the generating chamber through a gap between the tubular insertion portion and the connection pipe.

3. The apparatus for generating the vapor of the organic compound according to claim 2, wherein a measuring rod having a thread groove formed spirally in a lateral face with a lower end opened is inserted into the funnel-shaped vessel such that a lower end of the thread groove is positioned inside the tubular insertion portion, and by rotating the measuring rod, the organic material moves inside the thread groove, drops, and is fed into the transporting device from the tubular insertion portion.

4. The apparatus for generating the vapor of the organic compound according to claim 2, wherein the connection pipe comprises an outer connection pipe and an inner connection pipe, the inner connection pipe is arranged inside the outer connection pipe, a lower end of the inner connection pipe is positioned inside the generating chamber, the tubular insertion portion is inserted into the inner connection pipe, and a lower end of the tubular insertion portion is positioned inside the inner connection pipe.

5. The apparatus for generating the vapor of the organic compound according to claim 4, wherein a heat conductivity of the inner connection pipe is set lower than a heat conductivity of the outer connection pipe.

6. The apparatus for generating the vapor of the organic compound according to claim 4, wherein the outer connection pipe is provided with a cooling path through which a cooling medium flows.

7. The apparatus for generating the vapor of the organic compound according to claim 4, wherein the inner connection pipe is formed such that an apical portion positioned inside the generating chamber is tapered toward a tip.

8. The apparatus for generating the vapor of the organic compound according to claim 4, wherein a lower end of the tubular insertion portion is positioned inside the inner connection pipe, a gap is formed between the tubular insertion portion and the inner connection pipe, the gas is introduced into the gap through the gas introduction opening, and the introduced gas flows toward the lower end of the tubular insertion portion through the gas introduction opening.

9. The apparatus for generating the vapor of the organic compound according to claim 4, wherein each of the funnel-shaped vessel is constructed so as to be capable of being inserted into or pulled out from an interior of the inner connection pipe by moving up and down relative to the inner connection pipe, and an on/off valve is provided between the storage chamber and the transporting device, the on/off valve being capable of turning off a connection between an interior of the storage chamber and an interior of the transporting device when the tubular insertion portion is pulled out from the inner connection pipe.

10. The apparatus for generating the vapor of the organic compound according to claim 1, wherein a liquid-feeding vessel, in which a liquid of the organic compound is placed, and an ejection device for feeding the organic compound inside the liquid-feeding vessel into the transporting device are provided inside the storage chamber.

11. An apparatus for producing an organic thin film, comprising:
a film forming chamber;
a discharge device arranged inside the film forming chamber; and
an apparatus for generating a vapor of an organic compound according to any one of claims 1 to 10,
wherein an interior of the discharge device and an interior of the apparatus for generating the vapor of the organic compound are connected with each other via a connection valve for switching conduction and turning off of the vapor of the organic compound, an organic material moving from the storage chamber to the generating chamber through the transporting device generates a gas of the organic material by being heated in the generating chamber, and whereby the generated gas of the organic material is discharged into the film forming chamber through the discharge device.

12. The apparatus for producing the organic thin film according to claim 11, wherein the connection valve connects an interior of the generating chamber to a fixing device for fixing the vapor of the organic compound when the connection pipe turns off the connection between the interior of the discharge device and the interior of the generating chamber.
